# EUROPEAN PATENT APPLICATION

(11) **EP 1 855 517 A1**
(43) Date of publication of application: **14.11.2007**
(21) Application number: 07008977.6
(22) Date of filing: 03.05.2007
(51) Int. Cl.: H05K 3/34

(54) **Soldering structure of through hole**

(30) Priority: 08.05.2006 JP 2006129132
(71) Applicant: KABUSHIKI KAISHA TOKAI RIKA DENKI SEISAKUSHO, Niwa-gun, Aichi-ken 480-0195 (JP)
(72) Inventor: Suzuki, Norihito, Niwa-gun Aichi (JP); Minoura, Akihiro, Niwa-gun Aichi (JP)
(74) Representative: Grünecker, Kinkeldey, Stockmair & Schwanhäusser Anwaltssozietät

(57) **Abstract**

In the vicinity of soldering through holes of lands for soldering a lead terminal in a multilayer printed board, electrically isolated lands are provided to form a thermal through hole. In the soldering, by the radiation and supply of heat of a lead-free solder filled in the thermal through hole, it is possible to suppress the radiation of heat of the soldering through hole. Thus, it is possible to achieve a sufficient solder rise and to obtain an excellent soldering property.

## Description

### BACKGROUND OF THE INVENTION

The present invention relates to a soldering structure of a through hole in the case in which a lead terminal of an electronic component is soldered by using a lead-free solder for the through hole formed through a printed board.

In the case in which a through hole is formed to mount an electronic component including a lead terminal on a printed board, a lead is inserted in the through hole and is immersed in a molten solder in that state and the through hole portion is filled with the solder.

In the case in which the soldering is carried out, recently, an eutectic solder containing lead does not tend to be used in respect of an environmental pollution. Instead, a lead-free solder is being used.

In this case, the lead-free solder has a higher melting point than the eutectic solder. In some cases in which the soldering is carried out on assumption that an immersing condition for a molten soldering bath is set to be equivalent, therefore, a so-called "solder rise" is poor, that is, the solder does not sufficiently rise to an upper surface side of the through hole. As a result, a soldering failure is generated in some cases.

As a countermeasure, for example, it can be proposed to employ a method disclosed in Patent Document 1. More specifically, referring to the method disclosed in the Patent Document 1, in the case in which an electronic component is mounted on a printed board, a thermal conducting pin is formed to penetrate through a printed board in the vicinity of the through hole, and heat is thus supplied sufficiently to a solder entering the through hole, thereby enhancing the solder rise. Patent Document 1: JP-A-7-170061 Publication

However, the Patent Document 1 has disclosed the structure in which the thermal conducting pin is provided. For this reason, it is necessary to employ a structure in which the thermal conducting pin is previously inserted to penetrate through the printed board. A new component is required in respect of the structure, and furthermore, it is necessary to employ the structure in which the thermal conducting pin is provided also in respect of a manufacturing process.

### SUMMARY OF THE INVENTION

The invention has been made in consideration of the circumstances and has an object to provide a soldering structure of a through hole in which it is possible to enhance a soldering property without separately providing a thermal conducting pin also in the case in which the through hole is provided on a printed board and an electronic component having a lead terminal is soldered thereto by using a lead-free solder.

In order to achieve the object, the present invention is characterized by having the following arrangement.
(1) A soldering structure comprising:
   a printed board;
   a through hole which is formed through the printed board and to which an electric component having a lead terminal is to be soldered with a lead-free solder; and
   an auxiliary through hole for retaining solder, which is electrically isolated and formed through the printer board in the vicinity of the through hole.
(2) The soldering structure according to (1), wherein a distance between an edge of the through hole and an edge of the auxiliary through hole is equal to or smaller than 3 mm.
(3) The soldering structure according to (1), wherein a diameter of the auxiliary through hole is equal to or greater than 50% of that of the through hole.
(4) The soldering structure according to (2), wherein a diameter of the auxiliary through hole is equal to or greater than 50% of that of the through hole.
(5) The soldering structure according to (1), wherein a plurality of the auxiliary through holes are disposed and formed for one through hole.
(6) The soldering structure according to (2), wherein a plurality of the auxiliary through holes are disposed and formed for one through hole.
(7) The soldering structure according to (3), wherein a plurality of the auxiliary through holes are disposed and formed for one through hole.

According to the first aspect of the invention, the auxiliary through hole for retaining solder which is electrically isolated is provided in the vicinity of the through hole of the printed board. In the case in which the lead terminal of the electronic component is mounted on the through hole, therefore, the molten lead-free solder enters the through hole, and furthermore, the auxiliary through hole. By suppression in a heat radiation from a conductor pattern of the through hole and a supply of heat from the auxiliary through hole, consequently, it is possible to cause the molten solder in the through hole to sufficiently rise to an upper side of the through hole. Thus, it is possible to reliably solder the lead terminal.

According to the second aspect of the invention, the auxiliary through hole is disposed and formed in such a manner that the distance between the edges is equal to or smaller than 3 mm with respect to the through hole. By a suppression in a heat radiation from the through hole and the supply of heat from the auxiliary through hole, therefore, it is possible to reliably carry out the soldering.

According to the third aspect of the invention, the auxiliary through hole is formed in such a manner that a diameter is equal to or greater than 50% of that of the through hole. By the suppression in the heat radiation from the through hole and the supply of the heat from the auxiliary through hole, therefore, it is possible to reliably carry out the soldering in the same manner as described above.

According to the fourth aspect of the invention, a plurality of auxiliary through holes is disposed and formed for one through hole. Consequently, it is possible to enhance the advantages more greatly, thereby improving reliability.

### BRIEF DESCRIPTION OF THE DRAWINGS

Fig. 1 is a typical sectional view showing an embodiment according to the invention,
Fig. 2 is a plan view showing a state of an arrangement of a thermal through hole,
Fig. 3 is a view showing a set condition of an experiment for a date acquisition, and
Figs. 4A to 4C are graphs showing a result of an experiment for a solder rise.

### DETAILED DESCRIPTION OF PREFERRED EMBODIMENTS

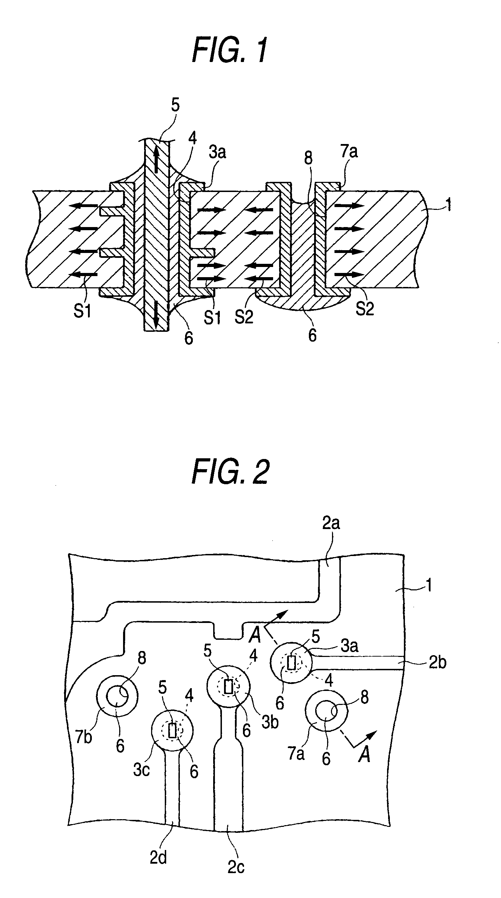

An embodiment according to the invention will be described below with reference to Figs. 1 to 4C.
Fig. 2 is a plan view showing a multilayer printed board 1 in which wiring conductor patterns 2a, 2b, 2c and 2d are formed on a surface, and furthermore, lands 3a, 3b and 3c for mounting an electronic component are provided and a soldering through hole 4 is formed through the lands 3a to 3c. A lead terminal 5 for an electronic component (not shown) is inserted in the soldering through holes 4 of the lands 3a to 3c and is electrically connected by a lead-free solder 6 in that state.

Moreover, lands 7a and 7b mounting no electronic component are disposed and formed in the vicinity of the lands 3a and 3c in the multilayer printed board 1. A thermal through hole 8 to be an auxiliary through hole according to the invention is formed through the lands 7a and 7b and is filled with the lead-free solder 6. The lands 7a and 7b having the thermal through holes 8 formed thereon are not electrically connected to other portions but serve to well perform a soldering treatment of the lead-free solder 6 which will be described below and are provided in a state in which they are not electrically connected to any portion.

The thermal through hole 8 is disposed and formed in a position of 3 mm or less, for example, with respect to the soldering through hole 4. Moreover, a diameter of the thermal through hole 8 is set to be equal to or greater than 50% of that of the soldering through hole 4.

Fig. 1 is a sectional view showing portions of the land 3a having the soldering through hole 4 formed thereon and the land 7a having the thermal through hole 8 formed thereon (a portion shown in an A - A line in the drawing) in the structure illustrated in Fig. 2. In Fig. 1, the multilayer printed board 1 is constituted by providing a plurality of wiring layers and a wiring conductor pattern is formed on upper and lower surface sides, and furthermore, is also formed on an intermediate layer in an inner part.

In the portion shown in the drawing, the soldering through hole 4 of the land 3a is filled with the lead-free solder 6 in a state in which the lead terminal 5 of an electronic component is inserted therein. In a state shown in the drawing, the lead-free solder 6 sufficiently rises up to the surface of the conductor pattern 2a formed on the upper surface of the multilayer printed board 1 so that an excellent soldering property can be obtained.

The thermal through hole 8 can obtain the following functions in the soldering treatment of the lead-free solder 6. Consequently, it is possible to reliably carry out the soldering treatment for the lead terminal 5 in the soldering through hole 4.

More specifically, in the soldering treatment of the lead-free solder 6 to the soldering through hole 4, the lead-free solder 6 crawls up in an immersion in a solder dipping bath, and the soldering through hole 4 and the thermal through hole 8 are filled with the lead-free solder 6. When the multilayer printed board 1 is pulled up from the solder dipping bath, next, the lead-free solder 6 is solidified with a drop in a temperature.

The heat of the lead-free solder 6 in the soldering through hole 4 is transferred from the inserted lead terminal 5 or the conductor patterns 2b, 2c and 2d connected to the lands 3a, 3b and 3c, and furthermore, is radiated through a transfer shown in an arrow Sl of the drawing in the multilayer printed board 1. On the other hand, the heat of the lead-free solder 6 in the thermal through hole 8 is radiated and supplied to the soldering through hole 4, thereby the radiation of the heat of the soldering through hole is suppressed and the drop in the temperature of the solder 6 in the soldering through hole 4 is moderated. Accordingly, a sufficient solder rise is achieved.

In case of the arrangement shown in Fig. 2, in the lands 3a to 3c having the soldering through hole 4 formed thereon, the two lands 3a and 3c are positioned in the vicinity of the land 3b. Therefore, equivalent advantages to those of the thermal through hole 8 can be obtained by the radiation and supply of heat through the lead-free solder 6 in the soldering through holes 4. Thus, the soldering can be carried out well. Referring to the lands 3a and 3c, moreover, the lands 7a and 7b having the thermal through holes 8 formed thereon are disposed and formed respectively, and furthermore, the soldering through hole 4 of the land 3a functions as the thermal through hole 8. Therefore, the soldering can be carried out well.

Next, description will be given to a result obtained by confirming, through an experiment, the advantages of the disposition and formation of the thermal through hole 8. The contents of the experiment are to find a condition for obtaining an excellent result in a change in the arrangement interval, diameter and arrangement number of the thermal through holes 8.

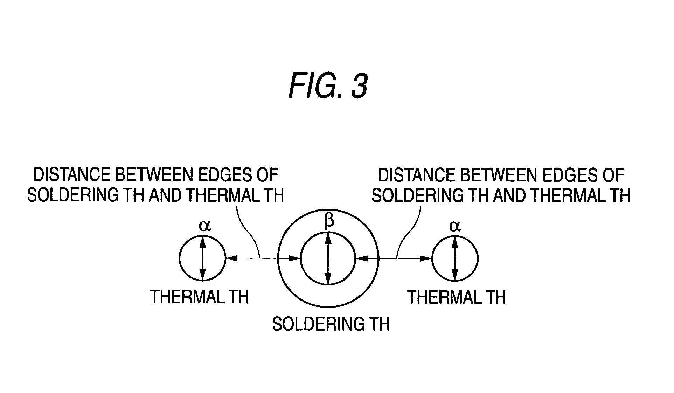

Fig. 3 is a typical view showing the condition of the experiment, illustrating a relationship between the soldering through hole (soldering TH) 4 and the thermal through hole (thermal TH) 8 which are formed through the multilayer printed board 1. A diameter of the thermal TH is represented by α, a diameter of the soldering TH is represented by β, an interval therebetween is represented by A, a diameter ratio α/β is represented by B, and the number of the thermals TH is represented by C. In a state shown in the drawings, in the case in which the number C of the thermals TH is set to be "2", they are disposed in opposite positions with the solder TH interposed therebetween.

A condition employed in the experiment is as follows. For a soldering process, a "lead-free flow soldering" method is taken. A lead-free solder to be a soldering material is an Sn - Ag - Cu based material, and more specifically, is an "Sn - 3.0Ag - 0.5Cu" solder. A soldering time is "10 seconds".

For an evaluation of the soldering, referring to whether an excellent solder rising state is obtained, points in four stages are counted as evaluation marks, that is, a state in which the solder rises up to a component surface and a fillet is formed is counted as "3" points, a state in which the solder rises up to the component surface is counted as "2" points, a state in which the solder rises to 75% of the soldering through hole or more and does not rise up to the component surface is counted as "1" point, and a state in which the solder rises to less than 75% of the soldering through hole is counted as "0" point, each of soldering numbers is set to be four points, and a full mark is set to be 12 points and the evaluation mark is caused to correspond to the condition, thereby carrying out plotting.

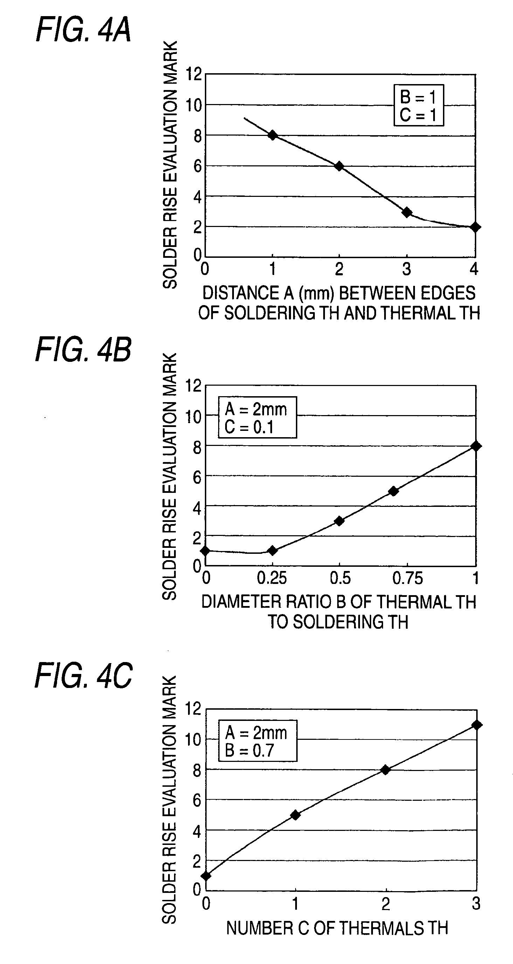

Figs. 4A to 4C show a result of the experiment, and Fig. 4A shows a condition of a distance A (mm) between the edges of the solder TH and the thermal TH, Fig. 4B shows a condition of a diameter ratio B, and Fig. 4C shows a condition of the number C of the thermals TH.

First of all, in Fig. 4A, the experiment was carried out, wherein the distance A between the edges of the soldering TH and the thermal TH is set to four conditions of "1 mm", "2 mm", "3 mm" and "4 mm", the diameter ratio B is set to be "1" and the number C of the thermals TH is set to be "1". As a result, it was found that the highest evaluation mark is obtained in case of "1 mm", and the evaluation mark is decreased with an increase in the distance A. It was decided that the advantages of the thermal TH can be expected when an upper limit of the distance A between the edges is approximately "3 mm".

In Fig. 4B, the experiment was carried out, wherein the diameter ratio B of the thermal TH to the solder TH is set to five conditions including four conditions of "0.25", "0.5", "0.75" and "1", and "0" for no thermal TH, the distance A between the edges is set to be "2 mm" and the number C in the case in which the thermal TH is provided is set to be "one". As a result, it was found that the diameter ratio B of "1" gives the highest evaluation mark, and the evaluation mark is decreased when the diameter ratio B is reduced. Moreover, the evaluation point was equal in case of the diameter ratio B of "0.25" and "0". For this reason, it was found that the advantages cannot be expected. Referring to the diameter ratio B, it was decided that the advantages can be expected in "0.3" or more, and preferably, approximately "0.5" (50%) or more.

In Fig. 4C, the experiment was carried out, wherein the four conditions of "0", "1", "2" and "3" are set to the number C of the thermals TH, the distance A between the edges is set to be "2 mm" and the diameter ratio B is set to be "0.7". As a result, it was found that the highest evaluation mark can be obtained with the number C of "3", and the evaluation mark is reduced with a decrease in the number C. Moreover, it was found that the advantages can be sufficiently obtained if the number C of the thermals TH is "1".

According to the embodiment, in the case in which the thermal through hole 8 is provided in the vicinity of the soldering through hole 4 of the multilayer printed board 1 to solder the lead terminal 5 with the lead-free solder 6, an excellent solder rising state can be obtained so that a soldering property can be enhanced.

In that case, it is possible to obtain excellent advantages if the distance A between the edges of the thermal through hole 8 and the soldering through hole 4 is equal to or smaller than "3 mm". It was found that excellent advantages can be obtained if the diameter ratio B therebetween is equal to or higher than "0.3", and preferably, is equal to or higher than "50% (0.5)". Furthermore, it was also found that the advantages can be expected more greatly if the number of the thermal through holes 8 to be disposed is equal to or greater than "1" and is increased.

By employing the conditions, actually, the following practical advantages could be obtained.
(1) In case of an A substrate, when there was set a condition that the diameter of the thermal through hole is set to be 1.3 mm, that is, the diameter ratio B is set to be 0.65 for the soldering through hole having a diameter of 2 mm and the distance A between the edges was set to be 1.5 mm, the solder rise could be enhanced more greatly as compared with the case in which the thermal through hole is not provided.

(2) In case of a B substrate, when there was set a condition that the diameter of the thermal through hole is set to be 1.4 mm, that is, the diameter ratio B is set to be 1.0 for the soldering through hole having a diameter of 1.4 mm and the distance A between the edges was set to be 1.5 mm, the solder rise could be considerably enhanced as compared with the case in which the thermal through hole is not provided.

The invention is not restricted to the examples but can be changed or enlarged in the following manner.
In the embodiment, the description has been given to the case in which the experiment was carried out on assumption that the lead terminal 5 had a square section. However, the sectional shape of the lead terminal 5 is not restricted to the square but may be a rectangle and a circular shape can also be applied thereto.

Although the lead-free solder used in the embodiment has been the Sn - Ag - Cu based material, moreover, it is also possible to use an Sn - Ag based material.

## Claims

1. A soldering structure comprising:
a printed board;
a through hole which is formed through the printed board and to which an electric component having a lead terminal is to be soldered with a lead-free solder; and
an auxiliary through hole for retaining solder, which is electrically isolated and formed through the printer board in the vicinity of the through hole.

2. The soldering structure according to claim 1, wherein a distance between an edge of the through hole and an edge of the auxiliary through hole is equal to or smaller than 3 mm.

3. The soldering structure according to claim 1, wherein a diameter of the auxiliary through hole is equal to or greater than 50% of that of the through hole.

4. The soldering structure according to claim 2, wherein a diameter of the auxiliary through hole is equal to or greater than 50% of that of the through hole.

5. The soldering structure according to claim 1, wherein a plurality of the auxiliary through holes are disposed and formed for one through hole.

6. The soldering structure according to claim 2, wherein a plurality of the auxiliary through holes are disposed and formed for one through hole.

7. The soldering structure according to claim 3, wherein a plurality of the auxiliary through holes are disposed and formed for one through hole.
